(19) Europäisches Patentamt
European Patent Office
Office européen des brevets

(11) **EP 3 339 242 B1**

(12) **FASCICULE DE BREVET EUROPEEN**

(45) Date de publication et mention
de la délivrance du brevet:
**19.06.2019 Bulletin 2019/25**

(51) Int Cl.:
***B81B 3/00*** *(2006.01)*    ***G01P 1/00*** *(2006.01)*
***G01P 15/00*** *(2006.01)*

(21) Numéro de dépôt: **17209139.9**

(22) Date de dépôt: **20.12.2017**

(54) **STRUCTURE MICROELECTRONIQUE COMPORTANT DES MOYENS DE CONTROLE DE L'AMORTISSEMENT VISQUEUX**

**MIKROELEKTRONISCHE STRUKTUR MIT KONTROLLMITTELN FÜR DIE VISKOSE DÄMPFUNG**

**MICROELECTRONIC STRUCTURE COMPRISING MEANS FOR CONTROLLING VISCOUS DAMPING**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.12.2016 FR 1663258**

(43) Date de publication de la demande:
**27.06.2018 Bulletin 2018/26**

(73) Titulaires:
• **COMMISSARIAT À L'ÉNERGIE ATOMIQUE ET AUX ÉNERGIES ALTERNATIVES**
**75015 Paris (FR)**
• **SAFRAN ELECTRONICS & DEFENSE**
**92100 Boulogne Billancourt (FR)**

(72) Inventeurs:
• **JOURDAN, Guillaume**
**38000 Grenoble (FR)**
• **LEHEE, Guillaume**
**92100 Boulogne-Billancourt (FR)**

(74) Mandataire: **Brevalex**
**95, rue d'Amsterdam**
**75378 Paris Cedex 8 (FR)**

(56) Documents cités:
• **GUILLAUME LEHÉE ET AL: "Low power damping control of a resonant sensor using back action in silicon nanowires", IEEE XPLORE DIGITAL LIBRARY, 29 février 2016 (2016-02-29), pages 99-102, XP055401408, 2016 IEEE 29th International Conference on MEMS, Shanghai 24-28 January 2016 ISBN: 978-1-5090-1973-1**

**Description**

**DOMAINE TECHNIQUE ET ÉTAT DE LA TECHNIQUE ANTÉRIEURE**

La présente invention se rapporte à des structures microélectromécaniques et/ou des structures nanoélectromécaniques à amortissement visqueux contrôlé.

Les systèmes microélectromécaniques ou MEMS (Microelectromechanical system en terminologie anglo-saxonne) et les structures nanoélectromécaniques ou NEMS (Nanoelectromechanical system en terminologie anglo-saxonne) comportent une partie fixe et au moins une masse mobile par rapport à un substrat, apte à être mis en vibration sous l'effet d'un stimulus extérieur, formant un résonateur.

Un résonateur ou oscillateur mécanique disposé dans un environnement gazeux subit un amortissement dû aux frottements avec le gaz lors du déplacement de la masse mobile, dit amortissement visqueux.

Le contrôle des processus d'amortissement ou de dissipation d'énergie mécanique dans un résonateur permettent d'augmenter la bande passante des MEMS et NEMS en réduisant l'intervalle de temps nécessaire pour retrouver l'équilibre avec le milieu extérieur. Plus généralement, le contrôle de la bande passante d'un résonateur mécanique peut être exploité pour réaliser des filtres de bande passante accordable. Enfin, la compensation des forces d'amortissement visqueux, via un tel contrôle, peut conduire le système en auto-oscillation. Cette propriété peut être exploitée pour réaliser des oscillateurs électromécaniques

Le contrôle de l'amortissement visqueux constitue un moyen efficace pour modifier la réponse électromécanique d'une structure MEMS/NEMS : le comportement mécanique d'un microsystème soumis à un stimulus extérieur peut être profondément redéfini que ce soit en termes de temps de réponse pour atteindre son régime stationnaire, de sensibilité à des perturbations proches de la fréquence de résonance, ou de capacité à réaliser un système auto-oscillant.

Plusieurs solutions existent pour modifier cet amortissement visqueux dans lequel se situe le résonateur. En effet, les modes de vibrations qui mettent en oeuvre des mouvements en interaction avec des lames d'air sont dominés par des processus d'amortissement pneumatiques lorsqu'ils sont placés sous air : par exemple des poutres en flexion, des masses en translation. Au voisinage de la pression ambiante, la dissipation est très sensible au niveau de pression. En revanche à basse pression, avec la raréfaction des molécules, le coefficient de dissipation évolue peu. Le facteur de qualité d'un MEMS peut être ainsi contrôlé par le niveau de pression dans une cavité dans laquelle se trouve l'élément mobile, obtenu par exemple par scellement hermétique. Cette solution ne permet pas un contrôle dynamique du facteur de qualité.

Par ailleurs, elle ne permet pas de contrôler indépendamment deux structures MEMS placées dans des cavités identiques. Par exemple, on peut souhaiter co-intégrer un dispositif qui nécessite un faible facteur de qualité, par exemple un accéléromètre, et un autre dispositif qui au contraire a besoin d'un facteur de qualité élevé, par exemple un gyromètre. En abaissant la pression dans la cavité, on influence les deux facteurs de qualité.

Une autre solution consiste à réaliser un contrôle actif du processus d'amortissement dans un MEMS. Pour cela, une force d'amortissement visqueux externe est générée. Une telle force est générée au moyen d'un actionneur contrôlable, via une électronique, dont la commande est proportionnelle à la vitesse du système mécanique mobile. Par exemple, ceci peut être réalisé en utilisant des moyens de détection du mouvement du MEMS/NEMS, un correcteur PID (proportionnel, intégral, dérivateur) et un actionneur, l'ensemble formant une boucle fermée. Cette solution est par exemple décrite dans le document *Yüceta$ M, Aaltonen L, Pulkkinen M, Salomaa J, Kalanti A, Halonen K. A charge balancing accelerometer interface with electrostatic damping. In: ESSCIRC (ESSCIRC), 2011 Proceedings of the. 2011. p. 291-4.* Un système mettant en oeuvre des moyens de détection et d'actionnement de type capacitif sont décrits. Bien que très efficace, cette solution nécessite la mise en oeuvre d'une électronique externe au système mécanique ainsi que de moyens de détection du mouvement du MEMS/NEMS. Il en résulte un encombrement important au niveau de l'électronique et une consommation énergétique élevée, ce qui limite l'emploi de cette configuration.

Le document Lehee G, Souchon F, Riou JC, Bosseboeuf A, Jourdan G. "Low power damping control of a resonant sensor using back action in silicon nanowires". In: 2016 IEEE 29th International Conference on Micro Electro Mechanical Systems (MEMS). 2016. p.99-102 décrit une solution utilisant le phénomène d'action en retour dans un élément piézorésistif ou TPBA (Thermo piezoresistive Back action). Il décrit un oscillateur comportant une masse mobile apte à osciller en rotation dans le plan et des nanojauges formées par des nanopoutres entre la masse et le substrat. Différentes positions des nanopoutres par rapport à l'axe du pivot sont testées. Les nanojauges subissent une compression ou une traction lors du déplacement de la masse. Les nanopoutres sont en silicium (SiNW) dopé au bore. Elles sont en matériau piézorésistif et thermoélastique.

Les nanopoutres sont polarisées électriquement, elles subissent un auto-échauffement $\Delta T = R_{th}P_j$ (I) qui est proportionnel à la puissance Joule $P_j = RI^2$ avec $R_{th}$ la résistance thermique de la poutre et $R$ la résistance électrique de la poutre.

Du fait de l'oscillation de la masse, les nanopoutres de longueur L subissent une élongation *x.*

Cette élongation provoque une modification de la résistance électrique de la poutre par piézorésistivité :

$$\delta R = \pi_g R \frac{x}{L}.$$

La puissance Joule est modifiée selon $\delta P = \delta R I^2$.

La température des poutres évolue vers une nouvelle valeur, soit une variation de $\delta T = R_{th} I^2 \delta R$ (II).

Ceci aboutit à un effort mécanique en retour produit par thermoélasticité : $F = E\alpha\delta T$ avec $E$ le module d'Young du matériau composant les nanopoutres, et $\alpha$ son coefficient de dilatation thermique.

Au final, une force proportionnelle au mouvement de la structure MEMS s'applique sur cette dernière :

$$F = E\alpha R_{th} I^2 \pi_g R \frac{x}{L}$$

Un effet de retard peut être induit par la résistance et l'inertie thermique des nanopoutres.

En effet une constante de temps thermique $\tau_{th} = R_{th} C_{th}$ apparaît en raison des limites de flux d'énergie thermique entre le système et l'extérieur. Cette constante de temps peut être vue comme un retard à la mise en place d'une nouvelle valeur de température. La variation de température peut être décrite par :

$$\delta T = R_{th} I^2 \delta R(t - \tau_{th}) \sim R_{th} I^2 \left( \delta R - \tau_{th} \delta \dot{R} \right)$$

$$F = E\alpha R_{th} I^2 \pi_g R \left( \frac{x}{L} - \tau_{th} \frac{\dot{x}}{L} \right)$$

La force en retour produite par le système de mesure comporte alors un terme visqueux :

$$F_v = -\Gamma_{BA} \dot{x}$$

Avec

$$\Gamma_{BA} = \frac{\tau_{th} E\alpha R_{th} I^2 \pi_g R}{L}.$$

Une modélisation plus approfondie du problème montre que la réponse harmonique de la force a en réalité la forme :

$$F(\omega) = E\alpha R_{th} I^2 \pi_g R \frac{x - j\tau_{th}\dot{x}}{1 + (\omega\tau_{th})^2}$$

La force de dissipation joue un rôle important au voisinage de la fréquence de résonance $\omega_r$ du système mécanique MEMS/NEMS. L'effet sera ainsi maximal lorsque la constante de temps atteindra une valeur telle que :

$$\tau_{th}\omega_r \sim 1$$

En effet, les cas limites suivants montrent :

$\tau_{th}\omega_r \ll 1$, le système adopte une température qui dépend instantanément de la position du MEMS /NEMS à l'échelle de la période d'oscillation.

$\tau_{th}\omega_r \gg 1$, la modulation de puissance due au mouvement produit une faible modulation de température de la structure TPBA améliorée. A l'échelle de la période d'oscillation, la quantité d'énergie thermique échangée entre la poutre TPBA et le circuit électrique est fortement réduite : la faible modulation de température génère une force thermoélastique de faible intensité.

Les nanopoutres présentent une forte résistance thermique et une faible capacité thermique : en l'état, il n'est pas aisé de contrôler indépendamment la constante de temps thermique $\tau_{th}$ et la fréquence de résonance de la structure $\omega_r$ dans laquelle elles interviennent. En outre plus les nanopoutres sont éloignées de l'axe du pivot plus la fréquence de résonance est élevée.

Il en résulte que l'effet TPBA est optimisé lorsque :

- la raideur des poutres domine la raideur globale de la structure,

- La constante de temps thermique se rapproche de la période d'oscillation $\tau_{th} \approx \frac{T}{2\pi}.$ Dans l'exemple ci-dessus, cela suppose une position optimale des jauges par rapport au pivot.

Or ces deux conditions ne sont pas toujours compatibles et un compromis est fait dans le dimensionnent de structures MEMS/NEMS.

## EXPOSÉ DE L'INVENTION

C'est par conséquent un but de la présente invention d'offrir une structure microélectronique comportant au moins une masse mobile à amortissement visqueux contrôlé, l'optimisation de l'amortissement étant découplé, au moins en grande partie, de la fréquence de résonance de la structure.

Le but énoncé ci-dessus est atteint par une structure microélectronique comportant au moins une masse mobile reliée mécaniquement à au moins un premier élément mécanique et un deuxième élément mécanique distincts par des premiers et deuxièmes moyens de liaison mécanique respectivement, et une source de polarisation en courant ou en tension des premiers moyens de liaison mécanique, le premier moyen de liaison mécanique comportant au moins deux éléments de liaison et un réservoir thermique interposé entre les deux éléments de liaison, au moins l'un des éléments de liaison étant au moins en partie en un matériau piézorésistif et au moins l'un des éléments de liaison présentant des propriétés de thermoélasticité. En outre, le réservoir thermique présente une capacité thermique différente de celles des éléments de liaison.

Selon l'invention, en mettant en oeuvre au moins un élément de liaison piézorésistif et au moins un élément de liaison thermoélastique, un effet d'action en retour apparaît, il en résulte une force en retour qui s'applique à la masse mobile. En mettant en oeuvre un réservoir thermique, la force en retour comporte un terme d'amortissement visqueux déterminé en partie par les caractéristiques du réservoir thermique. Ainsi, en dimensionnant le réservoir thermique on peut maximiser l'amortissement visqueux s'appliquant à la masse mobile.

Les inventeurs ont déterminé que la constante de temps thermique $\tau_{th}$ qui fixe le retard de la force dissipative pouvait être utilisée comme moyen de dimensionnement de la force dissipative, et que cette constante de temps peut être rendue quasiment indépendante de la raideur de la structure MEMS/NEMS.

Néanmoins le dimensionnement de la valeur de $\tau_{th}$ est complexe, notamment pour que sa modification n'ait pas d'influence sur la fréquence de résonance de la structure, puisque la constante de temps dépend entre autres de la géométrie de la poutre et des dimensions des éléments mécaniques en contact, qui ont une influence sur la fréquence de résonance.

Les inventeurs ont alors conçu des moyens de liaison entre la masse mobile et un élément mécanique comportant au moins deux éléments de liaison reliés entre eux par une zone de capacité thermique différente de celle des poutres , cette zone n'ayant pas ou très peu d'influence sur la raideur de l'élément de liaison et donc sur la fréquence de résonance de la structure. En choisissant cette capacité thermique, la constante de temps peut être fixée.

Grâce à l'invention, sans mettre en oeuvre d'électronique externe et de moyens de détection il est possible de contrôler l'amortissement visqueux par le dimensionnement d'un réservoir thermique. Il n'est pas non plus nécessaire de contrôler l'atmosphère autour de la structure.

En outre, la présente invention offre la possibilité d'ajuster simplement le facteur de dissipation d'un résonateur tout en conservant un niveau de bruit de force constant.

De manière avantageuse, la capacité thermique du réservoir thermique est supérieure aux capacités thermiques des poutres et très avantageusement est au moins égale à 5 fois la plus grande capacité thermique des deux éléments de liaison.

Dans un exemple de réalisation, les premier et deuxième éléments de liaison sont des poutres.

Le réservoir thermique peut présenter une épaisseur plus grande que celle des poutres et/ ou une surface dans le plan plus grande.

La présente invention a alors pour objet une structure microélectronique comportant au moins une masse mobile reliée mécaniquement à au moins un premier élément mécanique et un deuxième élément mécanique distincts par un premier dispositif de liaison mécanique et un deuxième dispositif de liaison mécanique respectivement, une source de polarisation en courant ou en tension du deuxième dispositif de liaison mécanique, dans laquelle le deuxième dispositif de liaison mécanique comporte au moins un premier et un deuxième éléments de liaison et au moins un réservoir thermique interposé entre les premier et deuxième éléments de liaison, au moins l'un des premier et deuxième éléments de liaison étant au moins partie en un matériau piézorésistif, au moins l'un des premier et deuxième éléments de liaison présentant des propriétés de thermoélasticité, et le réservoir thermique présentant une capacité thermique différente de celles des premier et deuxième éléments de liaison, et dans laquelle le deuxième dispositif de liaison et la masse mobiles sont disposés l'un par rapport à l'autre de sorte qu'un déplacement de la masse mobile applique une contrainte mécanique au deuxième dispositif de liaison.

De préférence, la capacité thermique du réservoir thermique est supérieure à celles des premier et deuxième éléments de liaison, avantageusement égale à au moins 5 fois la capacité thermique de chaque élément de liaison.

Le réservoir thermique peut présenter une section transversale de surface différente de celles des sections transversales des premier et deuxième éléments de liaison, et/ou le réservoir thermique peut être réalisé en au moins un matériau présentant une capacité thermique différente de celles des matériaux des premier et deuxième éléments de liaison, par exemple les premier et deuxième éléments de liaison sont en silicium et le réservoir thermique est en alliage d'aluminium ou en béryllium.

De préférence, le au moins un élément de liaison présentant des propriétés thermoélastiques est réalisé en au moins un matériau ayant un coefficient de dilatation supérieur à $10^{-7}K^{-1}$.

Par exemple, au moins l'un parmi le premier et le deuxième élément de liaison est en au moins un matériau piézorésistif présentant un coefficient de dilatation inférieur à $10^{-7}K^{-1}$ et au moins l'un parmi le premier et le deuxième élément de liaison est en au moins un matériau non piézorésistif et présentant un coefficient de dilatation supérieur à $10^{-7}K^{-1}$.

Selon l'invention le deuxième dispositif de liaison présente des propriétés à la fois piézorésistives et thermoélastiques. Ces propriétés sont réalisées par l'un et/ou l'autre des éléments de liaisons. Par exemple, seul un des éléments de liaison présente ces propriétés piézorésistives et thermoélastiques, ou les deux éléments de liaison présentent ces propriétés piézorésistives et thermoélastiques ou encore un des éléments de liaison présente des propriétés piézorésistives et l'autre élément de liaison présente des propriétés et thermoélastiques.

Avantageusement, les premier et deuxième éléments de liaison comportent chacun au moins une poutre droite.

Dans un exemple avantageux au moins l'un parmi les premier et deuxième éléments de liaison comporte au moins un nanofil.

Les raideurs des premier et deuxième éléments de liaisons et des connexions mécaniques entre le premier élément de liaison et la masse mobile, et entre le deuxième élément de liaison et le deuxième élément mécanique, sont de préférence telles qu'une dilatation du deuxième dispositif de liaison provoque principalement un effort sur la masse mobile.

Avantageusement la capacité du réservoir thermique est choisie de sorte que le deuxième dispositif de liaison présente une constante de temps thermique $\tau_{th}$ telle que que $\tau_{th}\omega_r \sim 1$ avec $\omega_r$ la fréquence de résonance de la structure microélectronique.

Dans un exemple de réalisation, des premier et deuxième éléments de liaison s'étendent selon une première direction, dans laquelle le réservoir thermique comporte une zone centrale reliée aux premier et deuxième éléments de liaison de section donnée dans la première direction et des zones latérales dans une deuxième direction transversale à la première direction, lesdites zones latérales présentant une dimension dans la première direction supérieure à ladite section donnée de la zone centrale.

Selon une caractéristique additionnelle, les moyens de polarisation sont connectés entre le premier élément mécanique et le deuxième élément mécanique, les premiers et deuxièmes dispositifs de liaison et la masse mobile étant tout ou partie conducteurs électriques.

Le réservoir thermique peut avantageusement présenter une résistance thermique au plus trois fois plus petite que les résistances thermiques des éléments de liaison.

Dans un exemple de réalisation, le premier élément mécanique est un plot d'ancrage solidaire d'un support et la masse mobile est articulée en rotation par rapport au plot d'ancrage et dans laquelle le deuxième élément mécanique est un deuxième plot d'ancrage solidaire du support.

Dans un autre exemple de réalisation, le premier élément mécanique est un plot d'ancrage solidaire d'un support et la masse mobile est mobile en translation le long d'une direction par rapport au support, et dans laquelle le deuxième élément mécanique comporte une masse mobile en translation par rapport au support le long de ladite direction, les deux masses mobiles étant en opposition de phase.

## BRÈVE DESCRIPTION DES DESSINS

La présente invention sera mieux comprise sur la base de la description qui va suivre et des dessins en annexe sur lesquels:

- la figure 1 est une représentation schématique d'un exemple de réalisation d'une structure microélectromécanique selon l'invention,
- la figure 2 est une vue de détail de la structure de la figure 1,
- la figure 3 est une vue de détail d'un autre exemple de moyens de liaison pouvant être mis en oeuvre dans la structure selon l'invention,
- la figure 4 est une vue de détail d'un autre exemple de moyens de liaison pouvant être mis en oeuvre dans la structure selon l'invention,
- la figure 5A est une vue de détail d'un autre exemple de moyens de liaison pouvant être mis en oeuvre dans la structure selon l'invention,
- la figure 5B est une vue de détail d'un autre exemple de moyens de liaison pouvant être mis en oeuvre dans la structure selon l'invention,
- la figure 6 est une vue de détail d'un autre exemple de moyens de liaison pouvant être mis en oeuvre dans la structure selon l'invention,
- la figure 7 est une représentation schématique d'un autre exemple de réalisation d'une structure microélectromécanique selon l'invention,
- les figures 8A à 8F sont des représentations schématiques des différentes étapes d'un exemple de procédé de réalisation d'une structure microélectronique selon la présente invention.

## EXPOSÉ DÉTAILLÉ DE MODES DE RÉALISATION PARTICULIERS

Dans la présente demande, on entend par structure microélectronique une structure comportant des éléments microélectromécaniques et/ou des éléments nanoélectromécaniques.

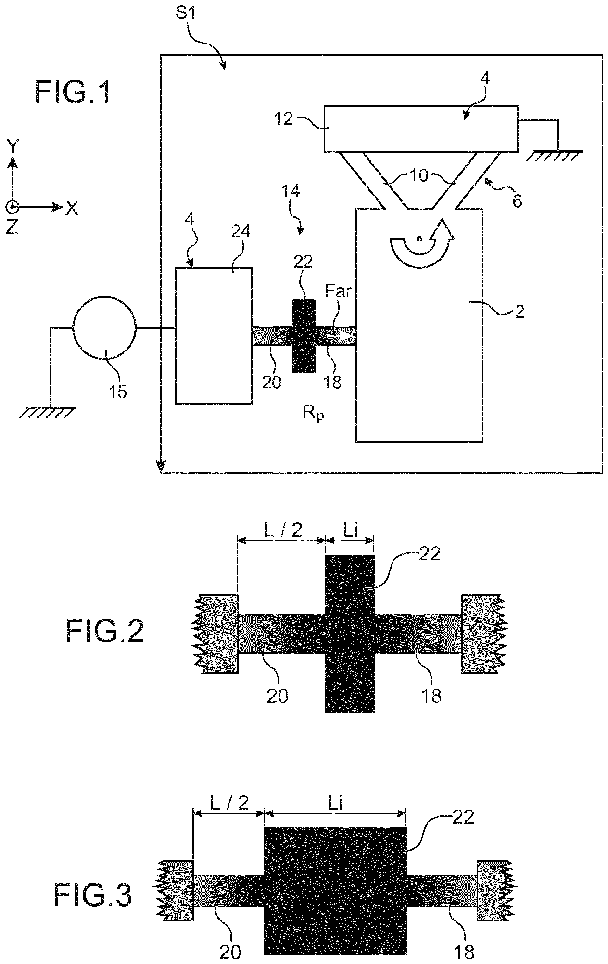

Sur la figure 1, on peut voir un exemple d'une structure microélectronique S1 selon l'invention. La structure s'étendant selon un plan moyen P défini par les axes X et Y. La structure comporte une masse mobile 2 apte à se déplacer par rapport à un support 4 formé par exemple par un substrat. La masse mobile 2 est reliée au support 4 par des premiers moyens de liaison 6 tels qu'ils autorisent un déplacement de la masse mobile 2 par rapport au support 4.

Dans l'exemple représenté, les premiers moyens de liaison 6 comporte une articulation pivot présentant un axe de pivot Z orthogonal au plan P. La masse mobile 2 est donc apte à se déplacer en rotation autour de l'axe Z dans le plan P. Dans l'exemple représenté, l'articulation pivot comporte deux poutres 10 s'étend entre un plot d'ancrage 12 et la masse mobile 2, les poutres 10 ayant des axes sécants en un point O qui est l'intersection de l'axe Z et du plan P. Les poutres 10 se déforment en flexion et autorisent la rotation de la masse autour de Z. Il sera compris que la liaison pivot pourrait être réalisée autrement.

La structure comporte des deuxièmes moyens de liaison 14 entre la masse mobile 2 et le support 4. Les deuxièmes moyens de liaison sont conducteurs électriques. La structure comporte également des moyens de polarisation 15 en courant ou en tension de ces deuxièmes moyens de liaison.

Comme cela sera décrit dans la suite de la description, les deuxièmes moyens de liaison 14 sont tels qu'ils exercent une force sur la masse mobile par action en retour thermo-piézorésistif. Les deuxièmes moyens de liaison 14 sont alors orientés par rapport aux premiers moyens de liaison 6, de sorte qu'ils soient sollicités mécaniquement par la masse mobile 2 en mouvement et, de sorte que la force d'action en retour Far s'applique au moins dans la direction selon laquelle la masse peut se déplacer. Dans cet exemple, la masse mobile 2 se déplace principalement selon la direction X. Les deuxièmes moyens de liaison 14 sont alors tels qu'ils exercent une force d'action en retour Far sur la masse le long de l'axe X.

Les deuxièmes moyens de liaison 14 sont sollicités par la masse mobile 2. De préférence ils sont sollicités en traction et en compression, tout en autorisant des mouvements en flexion en superposition de la compression ou de la traction.

Selon l'invention, les deuxièmes moyens de liaison 14, représentés seuls sur la figure 2, comportent au moins deux éléments de liaison 18, 20 reliés par un réservoir thermique 22.

L'élément de liaison 18 est ancré à la masse mobile 2 et au réservoir thermique 22 et l'élément de liaison 20 est ancré au réservoir thermique 22 et à un deuxième plot d'ancrage 24. Les deuxièmes moyens de liaison 14 sont tels qu'ils sont aptes à exercer des efforts mécaniques sur la masse mobile 2. Pour cela, ils présentent une certaine raideur et leur connexion au deuxième plot d'ancrage est telle que la force Far déplace préférentiellement la masse mobile. Dans cet exemple de réalisation, le deuxième plot d'ancrage n'est pas mobile.

De préférence, les raideurs relatives $k_e$ entre le deuxième plot d'ancrage et l'ancrage de la première poutre 18 à la masse 6 selon chacun des axes des poutres 18, 20 sont aussi proches que possible de la plus petite raideur axiale $k_p$ des poutres 18, 20, afin que les efforts générés par dilatation thermique dans au moins l'une des poutres s'appliquent sur les ancrages au lieu de favoriser le mouvement du réservoir thermique.

Avantageusement la structure est telle que :

$$k_e > 0{,}1 k_p$$

L'exemple de réalisation des deuxièmes moyens de liaison représenté sur la figure 1 est très favorable. Lorsque les deux poutres sont de raideur axiale $k_p$, la raideur de l'ensemble des deuxièmes moyens de liaison selon l'axe des poutres est proche de $k_p/2$.

Dans cet exemple et de manière avantageuse, les premier 18 et deuxième 20 éléments de liaison sont des poutres rectilignes, l'une 18 étant reliée à la masse mobile 2 et au réservoir thermique 22 par ses extrémités longitudinales, et l'autre 20 étant reliée au réservoir thermique 22 et au deuxième plot d'ancrage 24 par ses extrémités longitudinales.

De préférence les deux éléments de liaison 18, 20 présentent une longueur importante et une section transversale faible. La longueur des éléments de liaison est préférentiellement 5 fois plus grande que les dimensions transverses.

De préférence, les poutres 18 et 20 sont de dimensions identiques ou similaires, ce qui permet d'avoir à la fois des raideurs mécanique des deuxièmes moyens de liaison et une isolation thermique du réservoir thermique 22 optimales.

Au moins l'un des éléments de liaison 18, 20 est en matériau piézorésistif, par exemple en silicium. En outre au moins l'un des éléments de liaison 18, 20 présente des propriétés thermoélastiques. Par exemple au moins l'un des matériaux est réalisé en Si, Al, SiGe, SiN, $SiO_2$. Dans le cas du $SiO_2$ et du SiN, une piste conductrice est réalisée sur la poutre.

Dans la présente demande, on considère qu'un élément présente des propriétés thermoélastiques s'il présente un coefficient de dilatation à la température de travail supérieure à $10^{-7}K^{-1}$.

Le réservoir thermique 22 est tel qu'il présente une capacité thermique Cth différente des capacités thermiques des premier 18 et deuxième 20 éléments de liaison. De préférence Cth est supérieure aux capacités thermiques des éléments de liaison, très avantageusement supérieure à au moins 5 fois les capacités thermiques des éléments de liaison. Dans le cas où l'un des éléments de liaison présente une capacité thermique supérieure à celle de l'autre élément de liaison, Cth est supérieure à la capacité thermique la plus élevée et avantageusement 5 fois supérieure à celle-ci.

En outre, le réservoir thermique 22 est tel que la raideur des deuxièmes moyens de liaison est peu modifiée par rapport à des moyens de liaison sans réservoir, formés par exemple par une poutre unique.

Par exemple les deuxièmes moyens de liaison 14 sont d'un seul tenant et réalisés dans le même matériau par exemple en Si dopé n ou p, en AlSi, SiGe, en Au.

Dans ce cas, le réservoir présente au moins une section orthogonale à l'axe X de surface supérieure à la celle d'une section des poutres 18 et 20. Dans l'exemple représenté, la capacité thermique Cth est obtenue en réalisant une zone entre les poutres 18 et 20 de plus grande surface dans le plan P. En variante, le réservoir pourrait comporter les mêmes dimensions que les poutres dans le plan P mais une dimension selon la direction Z plus importante. En variante encore le réservoir pourrait comporter des dimensions supérieures dans le plan et dans la direction Z à celle des poutres, ou alors des dimensions inférieures dans le plan et une dimension supérieure dans la direction Z ou encore des dimensions supérieures dans le plan P et une dimension inférieure dans la direction Z. En variante, le réservoir thermique pourrait être réalisé en un matériau différent de celui des éléments de liaison présentant une capacité thermique différente de celles des matériaux des éléments de liaison 18, 20, avantageusement supérieure. Par exemple le réservoir thermique pourrait être réalisé en alliage à base d'aluminium, en béryllium et les éléments de liaison pourraient être réalisés en Si.

Le réservoir thermique 22 pourrait alors présenter les mêmes dimensions que les éléments de liaison 18, 20 tout en présentant une capacité thermique supérieure car il serait réalisé dans un matériau à capacité thermique supérieure, ou alors à la fois être en un matériau à capacité thermique supérieure à celle des matériaux des éléments de liaison et des dimensions différentes.

On peut envisager que le réservoir thermique comporte des matériaux différents. Dans le cas où le réservoir thermique aurait une épaisseur supérieure à celles des éléments de liaison, par exemple l'augmentation d'épaisseur peut être obtenue avec le dépôt d'un autre matériau, tel que du AlSi ou du Be.

Les moyens de polarisation comportent un générateur de tension ou de courant relié aux plots d'ancrage. La masse mobile et les premiers moyens de liaison sont alors également conducteurs électriques ou possèdent des pistes réalisées dans un matériau conducteur électrique.

En variante, on peut envisager de brancher le générateur entre le deuxième plot d'ancrage et l'extrémité de la poutre 18 ancrée sur la masse mobile. Pour cela, un élément de liaison électrique peut être introduit pour être en contact avec l'ancrage situé sur la partie mobile. Cet élément peut avoir la forme d'un serpentin formant ressort, afin de ne pas introduire de raideur supplémentaire sur la masse mobile.

Le fonctionnement de la structure de la figure 1 va maintenant être décrit en considérant un réservoir thermique présentant une capacité thermique supérieure à celles des poutres 18, 20.

Les deuxièmes moyens de liaison, i.e. les deux poutres 18 et 20 et le réservoir thermique 22 sont polarisés en tension ou en courant.

Les poutres subissent un auto-échauffement par effet Joule.

Lorsque la masse mobile 2 est mise en mouvement par un stimulus extérieur, par exemple une accélération, elle se déplace autour de l'axe Z et sollicite en traction ou en compression les poutres 18 et 20.

Puisqu'au moins l'une des poutres 18, 20 est en matériau piézorésistif, la résistance électrique de la poutre varie, puis la puissance dissipée par effet Joule, ce qui a pour effet de modifier la température de la poutre et plus généralement des deuxièmes moyens de liaison.

Or, puisqu'au moins l'un des éléments de liaison 18, 20 possède des propriétés thermoélastiques, une force d'action en retour est générée par déformation de cet élément qui s'applique sur la masse mobile.

Far peut être décrite par la formule III.

$$F(\omega) = E\alpha R_{th} I^2 \pi_g R \frac{x - j\tau_{th}\dot{x}}{1 + (\omega\tau_{th})^2} \text{ (III)}$$

On en déduit que l'effet de la force Far est maximal lorsque la constante de temps atteindra une valeur telle que :

$$\tau_{th}\omega_r \sim 1$$

Grâce à l'invention, il est possible de régler la valeur de $\tau_{Th}$ afin de remplir la condition $\tau_{th}\omega_r \sim 1$ et ceci sans avoir à modifier la valeur de la fréquence de résonance de la structure.

En effet, le réservoir thermique 22 augmente l'inertie thermique des deuxièmes moyens de liaison, ce qui a pour effet d'augmenter la constante de temps thermique. En effet le réservoir thermique, du fait de sa capacité thermique Cth plus élevée que celles de poutres, tend à « absorber » la chaleur davantage que les poutres et donc à retarder la variation de température induit par la modification d'effet Joule due au mouvement de la masse.

En augmentant l'inertie thermique, les effets mécaniques en retour sur la structure sur laquelle les éléments de liaison s'appuient sont retardés. Cette augmentation de l'inertie thermique est optimisée par le fait que le réservoir thermique est relié au reste de la structure uniquement par les poutres, afin de maximiser l'isolation thermique. Les poutres sont soumises à un échauffement contrôlé par le réservoir thermique disposé entre les poutres, les efforts mécaniques exercés par chaque élément de poutres sur ses ancrages fixes ou mobiles sont alors synchronisés.

Dans un exemple particulièrement intéressant, l'une des poutres seulement 18, 20 est en matériau piézorésistif et a un faible coefficient de dilatation, i.e. inférieure à $10^{-7}K^{-1}$, et l'autre poutre 20, 18 n'est pas piézorésistive et présente des propriétés thermoélastiques, i.e. un coefficient de dilatation supérieur à $10^{-7}K^{-1}$. Cette réalisation permet d'optimiser le choix du matériau piézorésistif et du matériau thermoélastique pour exploiter au mieux l'effet d'action en retour.

Sur les figures 2 à 4, on peut voir d'autres exemples de réalisation des deuxièmes moyens de liaison. A titre de comparaison, on considère une structure dans laquelle les deuxièmes moyens de liaison seraient une simple poutre de longueur L, reliant la partie mobile 2 au deuxième plot d'ancrage 24.

Sur les différentes figures 2 à 4, Li désigne la dimension du réservoir thermique dans la direction X.

Sur la figue 2, le réservoir thermique 22 a une dimension importante dans la direction Y et une dimension faible dans la direction X. Chaque poutre 18, 20 a une longueur L/2.

Sur la figure 3, le réservoir thermique 22 présente des dimensions proches dans les directions X et Y, ce qui permet d'avoir une thermalisation rapide du réservoir thermique 22. Chaque poutre a une longueur L/2.

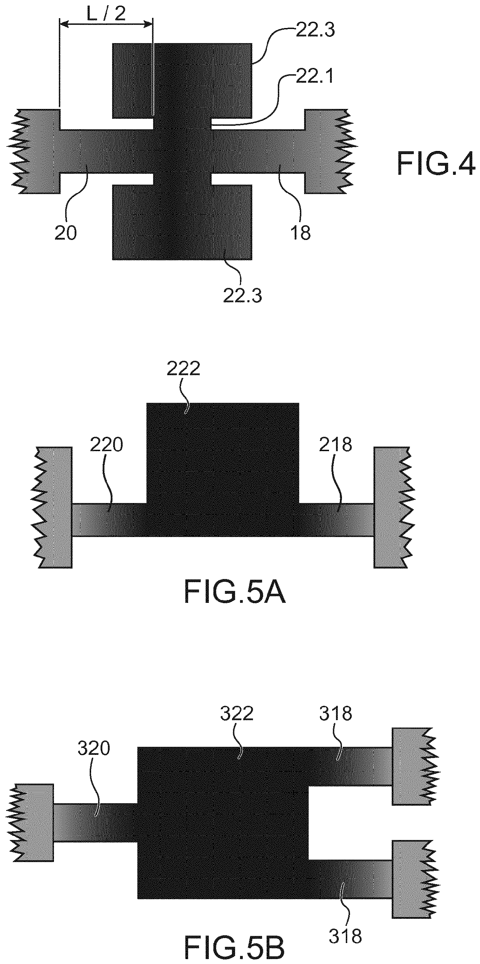

Sur la figure 4, le réservoir thermique comporte une portion centrale 22.1 de dimension selon l'axe X réduite et deux portions d'extrémité 22.3 de dimensions selon la direction X plus grande. Chaque poutre a une longueur L/2. Cette réalisation a pour avantage de pouvoir conserver des deuxièmes moyens de liaison dont la dimension totale le long de l'axe X est proche de la somme des dimensions selon X des deux poutres. Ainsi l'intégration du réservoir thermique a un impact réduit sur l'encombrement de la structure.

Les deuxièmes moyens de liaison des figures 2 à 4 ont une raideur proche d'une poutre unique de longueur L, ce qui permet de peu ou pas modifier les modes de vibration de l'ensemble de la structure. En outre, de préférence, la résistance électrique du réservoir thermique est faible. Préférentiellement on peut considérer que $R_{Res} < 0.5 R_{poutre}$, ce qui permet de conserver une résistance électrique du même ordre de grandeur que celle fixée par les poutres 18, 20 de plus faible section et, qui est proche ou égale à celle d'une poutre unique. L'augmentation de la consommation électrique de la structure est alors limitée.

De préférence, la résistance thermique du réservoir thermique est faible, avantageusement elle est au plus trois fois plus petite que les résistances thermiques des poutres, et de préférence 5 fois plus petite que les résistances thermiques des poutres, ce qui favorise une répartition rapide de l'énergie thermique vers le plateau et non vers les ancrages des poutres au deuxième plot.

A volume de réservoir thermique donné, un réservoir de forme compact selon les trois dimensions est préféré afin de favoriser la répartition rapide de l'énergie au sein de ce plateau.

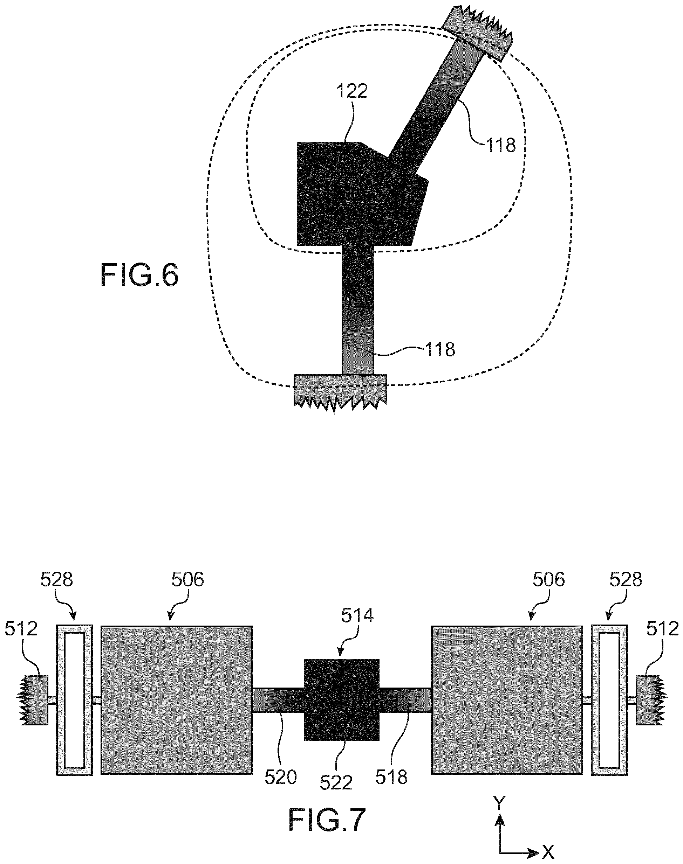

Sur la figure 6, on peut voir un autre exemple de réalisation des deuxièmes moyens de liaison dans lesquels les éléments de liaison 118, 120 ne sont pas parallèles et ne sont pas alignés. Le réservoir thermique 122 a la forme d'un pentagone.

Concernant les éléments de liaison, ils sont préférentiellement formés par des poutres rectilignes mais il peut être envisagé qu'ils comportent plusieurs portions de poutres dont les axes forment un angle entre eux. L'angle est choisi faible de sorte que l'action en retour dans les deuxièmes moyens de liaison serve préférentiellement à appliquer un effort sur les ancrages et non à déformer les éléments de liaison.

Sur la figure 5A, on peut voir encore un autre exemple de réalisation des deuxièmes moyens de liaison dans lequel les éléments de liaison 218, 220 sont connectés au réservoir thermique 222 sur un bord de celui-ci et non dans la partie centrale de celui-ci. Les deuxièmes moyens de liaison ne présentent pas de plan de symétrie contenant X et Z.

Sur la figure 5B, on peut voir encore un autre exemple de réalisation des deuxièmes moyens de liaison comportant plusieurs premiers éléments de liaison 318 et un deuxième élément de liaison 320 reliés au réservoir thermique 322. On pourrait envisager qu'ils comportent alternativement ou en plus plusieurs deuxièmes éléments de liaison 320.

Dans un autre exemple de réalisation avantageux, on peut envisager de remplacer les poutres formant les éléments de liaison par des poutres de section submicrométrique, plus particulièrement par des nanofils dont les dimensions dans un plan perpendiculaire à leur longueur sont inférieur à environ 500 nm, dont la somme des sections de tous les nanofils serait proche ou identique de celle de la poutre 18 ou 20. La résistance thermique des éléments de liaison est alors avantageusement augmentée. En effet la conductivité thermique de nanofils en silicium chute de plusieurs ordres de grandeur à ces dimensions. Il est alors possible de réaliser une structure avec la même raideur et la même résistance électrique et une résistance thermique augmentée. Cette augmentation de la résistance thermique permet de favoriser une évacuation de l'énergie thermique vers le plateau et non vers les ancrages des poutres au deuxième plot d'ancrage et à la masse.

Cette possibilité d'augmenter la résistance thermique permet de disposer d'un degré de liberté supplémentaire pour modifier la constant de temps thermique. Le nombre de possibilités dans la réalisation des structures réalisables est alors augmenté.

Sur la figure 7, on peut voir un autre exemple de structure microélectronique selon l'invention.

Cette structure diffère de celle de la figure 1 en ce que d'une part elles comportent deux masses mobiles 506 reliées par les deuxièmes moyens de liaison 514 selon l'invention comportant un réservoir thermique 522 et deux poutres 518, 520. En outre, les masses mobiles 506 sont suspendues à des plots d'ancrage 512, 524 par des ressorts 528, permettant aux masses mobiles de se déplacer dans le plan le long de l'axe X et de vibrer en opposition de phase. Le réservoir thermique est alors immobile le long de l'axe X, ce qui permet de ne pas restreindre les dimensions du réservoir thermique.

En effet, la structure possède un mode de vibration pour lequel les deux masses vibrent en opposition de phase. Pour ce mode, la masse du réservoir thermique peut être quelconque car son inertie ne participe pas aux propriétés du mode (inertie, fréquence de résonance).

Il est à noter qu'une structure, dans laquelle les deux masses mobiles seraient en phase n'applique pas de déformation aux éléments de liaison et n'est pas soumise à un effet d'action en retour.

La masse peut avoir tout mouvement, des mouvements linéaires ou en rotation. En outre les mouvements peuvent être des mouvements dans le plan, des mouvements hors-plan et/ou une combinaison de mouvements dans le plan et de mouvements hors-plan.

De manière générale, le réservoir thermique peut participer à l'inertie globale du MEMS ou du NEMS. Cela peut modifier la fréquence de résonance du système par exemple. On cherche alors de manière préférée à avoir une masse du réservoir thermique négligeable par rapport au reste de la structure, par exemple une masse inférieure à 20% de la masse de la structure. C'est par exemple le cas dans la structure de la figure 2.

Dans les exemples décrits les deuxième moyens de liaison comportent un réservoir thermique mais il pourrait être envisagé qu'ils comportent plusieurs réservoirs thermiques, par exemple deux réservoir thermiques reliés par une poutre, les deuxièmes moyens de liaison comportant alors trois poutres et deux réservoirs thermiques.

Grâce à l'invention, la constante de temps thermique du système de poutres générant l'effet d'action en retour peut être choisie en dimensionnant le ou les réservoirs thermiques, en modifiant très faiblement les paramètres mécaniques associés au MEMS (raideur, inertie mécanique, etc.) et les résistances électriques associées aux poutres d'action en retour. Ainsi il est possible de réaliser une structure permettant de remplir, ou au moins de se rapprocher de la condition $\tau_{th}\omega_r \sim 1$ pour laquelle le contrôle de la force de dissipation visqueuse est la plus favorable.

L'inertie thermique peut être modifiée de 1 à 3 ordres de grandeur, i.e. multiplié par un facteur entre 10 et 1000 en étendant le réservoir thermique dans les directions transversales à la direction principale des poutres. Par exemple considérons une poutre de 5 μm de long et 250 nm de largeur et d'épaisseur, son inertie thermique peut être augmentée au moins d'un facteur 100 en intercalant un réservoir thermique de dimensions 5 μm x 2.5 μm x 2.5μm entre deux demi-poutres.

L'effet d'action en retour thermo-piézorésistif permet de changer la réponse mécanique d'un résonateur MEMS/NEMS sans modifier le bruit de force d'origine thermique, à l'inverse des systèmes d'amortissement pneumatique (contrôle de la pression dans la cavité MEMS/NEMS). Dans le cas des systèmes d'amortissement actif, une électronique complexe doit être mise en oeuvre : en réinjectant du bruit de mesure dans la force de rétroaction, un bruit de force est généré sur le MEMS, ce qui peut réduire ses performances.

La présente invention est particulièrement efficaces pour des fréquences travail pour lesquelles la majeure partie de l'énergie cinétique de la structure microélectronique se situe dans la masse mobile, de préférence au moins 70%.

Dans le cas de la structure de la figure 2, les fréquences de travail peuvent être comprises entre 1 kHz et 100 kHz, par exemple entre 3 kHz et 20 kHz.

Dans le cas de la structure de la figure 7, les fréquences de travail peuvent être de l'ordre de 1 MHz, voire quelques dizaines de MHz sans que cela soit limitatif.

A titre d'exemple uniquement, la constante de temps thermique d'une structure selon l'invention va être estimée. Les deuxièmes moyens de liaison comportent :

- deux poutres de longueur 2,5 μm et de section 250 x 250 nm$^2$ en silicium,
- un réservoir thermique de dimensions 5 x 5 μm$^2$ et d'épaisseur 250 nm en silicium également.

La capacité thermique massique du silicium est approchée par celle du silicium massif à 700 J/kg. La conductivité thermique est prise égale à 80 W/m/K pour du silicium dopé p à 5. $10^{-19}$ cm$^{-3}$ en raison de la faible section de la poutre. Dans le cas du silicium massif, la conductivité thermique est égale à 148 W/m/K.

En considérant un modèle simplifié qui concentre l'inertie thermique dans le réservoir thermique et la résistance thermique dans les poutres, une estimation de la constante de temps thermique peut être réalisée. Ce modèle apparait raisonnable compte tenu des différences de dimensions entre ces éléments :

- La résistance thermique du système connecté à l'extérieur par les deux poutres est estimée à 0.25 MK/W. Les deux poutres sont en parallèle d'un point de vue thermique $R_{th} = \frac{1}{2} \frac{L}{\gamma_{th} S}$

La capacité thermique du réservoir thermique est quant à elle estimée à 10,2 pJ/K.

Une constante thermique de l'ordre de 2,5 μs est estimée. En l'absence de réservoir thermique (les deuxièmes éléments de liaison ne comporteraient qu'une poutre de 5 μm de long et 250 nm de largeur et d'épaisseur), une constante de temps dans la gamme 50 ns soit près de deux ordres de grandeur en dessous. Si l'épaisseur du réservoir thermique est portée à 2,5 μm, la constante de temps peut atteindre 25 μs, soit près de trois ordres de grandeur au-dessus de la poutre seule.

Pour se rapprocher de la condition $\tau_{th}\omega_r \sim 1$, avec une constante de temps de 25 μs, la gamme de fréquence de résonance de la structure MEMS/NEMS que l'on peut adresser avec une poutre de dimension 5 μm x 250 x 250 nm$^2$ se situe entre 7 kHz et 3.5 MHz : ces ordres de grandeurs sont compatibles avec de nombreuses applications MEMS/NEMS tels que des gyromètres, accéléromètres, etc. en utilisant des poutres de dimensions plus petites, l'effet peut être accordé pour des fréquences dans la gamme de la dizaine à la centaine de MHz.

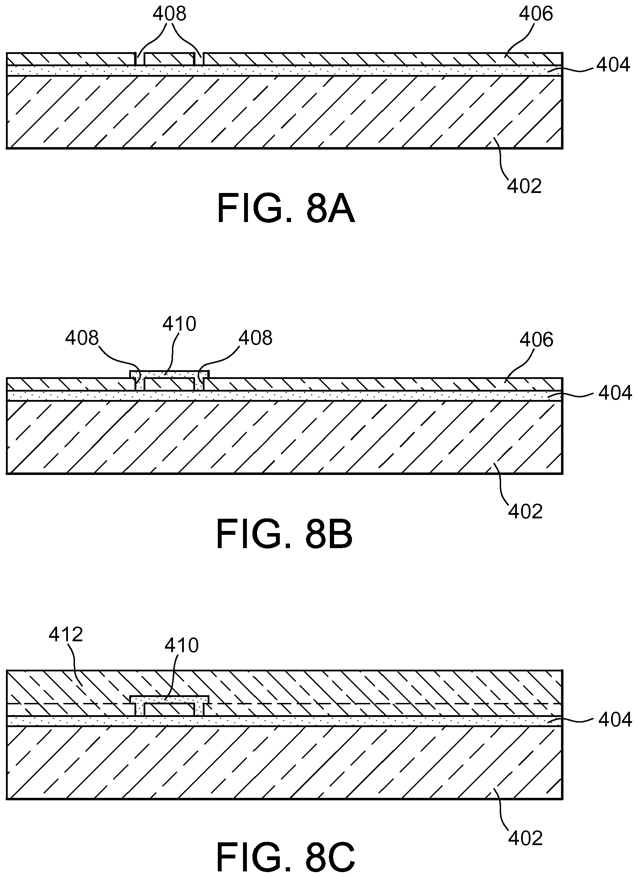

Nous allons maintenant décrire un tel procédé de réalisation d'une structure selon la présente invention, dont on peut voir représentées schématiquement différentes étapes sur les figures 8A à 8F.

On utilise, par exemple une structure SOI (Silicium on insulator) comportant un substrat 402, une couche d'oxyde enterré BOX (Buried oxide) 404, et une couche de silicium 406. La couche de silicium 406 a par exemple une épaisseur de l'ordre de 200 nm. D'une manière générale, la couche 406 peut être du Si, SiGe ou Ge poly ou monocristallin.

On réalise ensuite une structuration de la couche de silicium 406, par exemple par photolithographie et gravure avec arrêt sur la couche d'oxyde 406, ce qui permet de définir les moyens de liaison.

L'élément ainsi obtenu est représenté sur la figure 8A.

Lors d'une étape suivante, on effectue un dépôt d'une couche d'oxyde 410 sur la couche silicium 406 pour combler les zones 408 préalablement gravées, on effectue ensuite une gravure de la couche d'oxyde 410 pour ne laisser subsister qu'une portion d'oxyde déposé sur la couche de silicium 406 et reliant l'oxyde remplissant les tranchées. La gravure peut être réalisée par gravure sèche avec arrêt sur Si ou par gravure humide, par exemple en utilisant une solution à base d'acide sulfurique. Dans le cas où le réservoir thermique présente une épaisseur différente à celle des éléments de liaison, il peut être prévu de la zone destinée à former le réservoir thermique.

L'élément ainsi obtenu est représenté sur la figure 8B.

Lors d'une étape suivante, on forme un dépôt d'une couche de silicium 412. La couche 412 est obtenue par exemple, par croissance épitaxiale, et présente une épaisseur typique de 1 à 50$\mu$m, par exemple 10$\mu$m. Plus généralement, la couche 412 peut être constituée de Si, SiGe, Ge, poly ou monocristallin ou d'un matériau métallique ; le dépôt peut être réalisé par épitaxie ou par des méthodes de type dépôt physique/chimique en phase vapeur (PVD/CVD : Physical/Chemical Vapor Déposition).

L'élément ainsi obtenu est représenté sur la figure 8C.

Lors d'une étape suivante, on réalise des contacts électriques 414. Pour cela, on effectue un dépôt d'une couche métallique (AlSi ou Au par exemple), on distingue les zones à supprimer et à conserver par photolithographie. On grave ensuite par gravure sèche avec arrêt sur Si ou par gravure humide sélective par rapport au Si la couche métallique pour ne conserver que les contacts 414.

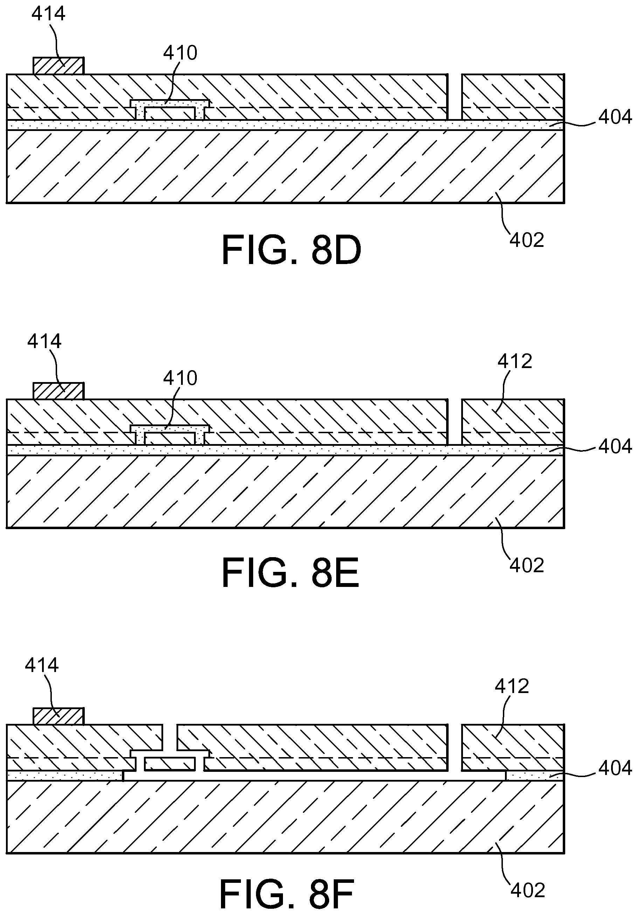

L'élément ainsi obtenu est représenté sur la figure 8D.

Lors d'une étape suivante, on structure les couches de silicium 406 et 412 pour définir la masse mobile et les premiers moyens de liaison et les deuxièmes moyens de liaison, par exemple par photolithographie et gravure profonde avec arrêt sur les couches d'oxyde 404 et 410.

L'élément ainsi obtenu est représenté sur la figure 8E.

Lors d'une étape suivante, on libère la masse mobile et les premiers et deuxièmes moyens de liaison, par exemple par gravure humide de l'oxyde 404, par exemple au moyen d'acide fluorhydrique (HF) liquide et/ou vapeur. Il s'agit d'une gravure au temps. L'acide fluorhydrique est laissé au contact de la couche d'oxyde le temps nécessaire pour libérer la masse mobile, les premiers et deuxièmes moyens de liaison tout en laissant la couche d'oxyde entre le substrat et les parties fixes.

L'élément ainsi obtenu est représenté sur la figure 8F.

Les micro et nanostructures MEMS/NEMS selon l'invention offrant des moyens de contrôle de l'amortissement visqueux peuvent par exemple être mises en oeuvre dans les micro-capteurs et les micro-actionneurs MEMS/NEMS.

## Revendications

1. Structure microélectronique résonante comportant :

   - au moins une masse mobile (2) reliée mécaniquement à au moins un premier élément mécanique et un deuxième élément mécanique distincts par un premier dispositif de liaison mécanique (6) et un deuxième dispositif de liaison mécanique (14) respectivement, ladite masse étant configurée pour être mise en vibration par un stimulus extérieur,
   - une source de polarisation (15) en courant ou en tension du deuxième dispositif de liaison mécanique (14), dans laquelle le deuxième dispositif de liaison mécanique (14) comporte au moins un premier (18) et un deuxième (20) élément de liaison et au moins un réservoir thermique (22) interposé entre les premier et deuxième éléments de liaison, au moins l'un des premier et deuxième éléments de liaison étant au moins partie en un matériau piézorésistif, au moins l'un des premier et deuxième éléments de liaison présentant des propriétés de thermoélasticité, et le réservoir thermique (22) présentant une capacité thermique supérieure à celles des premier (18) et deuxième (20) éléments de liaison, dans laquelle le deuxième dispositif de liaison (14) et la masse mobiles (2) sont disposés l'un par rapport à l'autre de sorte qu'un déplacement de la masse mobile (2) applique une contrainte mécanique au deuxième dispositif de liaison (14).

2. Structure microélectronique résonante selon la revendication 1, dans laquelle la capacité thermique du réservoir thermique (22) est supérieure à celles des premier (18) et deuxième (20) éléments de liaison, avantageusement égale à au moins 5 fois à la capacité thermique de chaque élément de liaison (18, 20).

3. Structure microélectronique résonante selon les revendications 1 ou 2, dans laquelle le réservoir thermique (22) présente une section transversale de surface différente de celles des sections transversales des premier (18) et deuxième (20) éléments de liaison.

4. Structure microélectronique résonante selon l'une des revendications 1 à 3, dans laquelle le réservoir thermique (22) est réalisé en au moins un matériau présentant une capacité thermique différente de celles des matériaux des premier (18) et deuxième (20) éléments de liaison, par exemple les premier (18) et deuxième (20) éléments de liaison sont en silicium et le réservoir thermique est en alliage d'aluminium ou en béryllium.

5. Structure microélectronique résonante selon l'une des revendications 1 à 4, dans laquelle le au moins un élément de liaison présentant des propriétés thermoélastiques est réalisé en au moins un matériau ayant un coefficient de dilatation supérieur à $10^{-7}K^{-1}$.

6. Structure microélectronique résonante selon l'une des revendications 1 à 5, dans laquelle au moins l'un parmi le premier et le deuxième élément de liaison est en au moins un matériau piézorésistif présentant un coefficient de dilatation inférieur à $10^{-7}K^{-1}$ et au moins l'un parmi le premier et le deuxième élément de liaison est en au moins un matériau non piézorésistif et présentant un coefficient de dilatation supérieur à $10^{-7}K^{-1}$.

7. Structure microélectronique résonante selon l'une des revendications 1 à 6, dans laquelle les premier (18) et deuxième (20) éléments de liaison comportent chacun au moins une poutre droite.

8. Structure microélectronique résonante selon l'une des revendications 1 à 7, dans laquelle au moins l'un parmi les premier et deuxième éléments de liaison comporte au moins un nanofil.

9. Structure microélectronique résonante selon l'une des revendications 1 à 8, dans laquelle les raideurs des premier (18) et deuxième (20) éléments de liaisons et des connexions mécaniques entre le premier élément de liaison et la masse mobile et entre le deuxième élément de liaison et le deuxième élément mécanique sont telles qu'une dilatation du deuxième dispositif de liaison provoque principalement un effort sur la masse mobile.

10. Structure microélectronique résonante selon l'une des revendications 1 à 9, dans laquelle la capacité du réservoir thermique (22) est choisie de sorte que le deuxième dispositif de liaison (14) présente une constante de temps thermique $\tau_{th}$ telle que que $\tau_{th}\omega_r \sim 1$ avec $\omega_r$ la fréquence de résonance de la structure microélectronique.

11. Structure microélectronique résonante selon l'une des revendications 1 à 10, dans laquelle des premier et deuxième éléments de liaison s'étendent selon une première direction, dans laquelle le réservoir thermique comporte une zone centrale reliée aux premier et deuxième éléments de liaison de section donnée dans la première direction et des zones latérales dans une deuxième direction transversale à la première direction, lesdites zones latérales présentant une dimension dans la première direction supérieure à ladite section donnée de la zone centrale.

12. Structure microélectronique résonante selon l'une des revendications 1 à 11, dans laquelle les moyens de polarisation (15) sont connectés entre le premier élément mécanique (12) et le deuxième élément mécanique (24), les premiers (6) et deuxièmes (14) dispositifs de liaison et la masse mobile (2) étant tout ou partie conducteurs électriques.

13. Structure microélectronique résonante selon l'une des revendications 1 à 12, dans laquelle le réservoir thermique présente une résistance thermique au plus trois fois plus petite que les résistances thermiques des éléments de liaison.

14. Structure microélectronique résonante selon l'une des revendications 1 à 13, dans laquelle le premier élément mécanique (12) est un plot d'ancrage solidaire d'un support et la masse mobile (2) est articulée en rotation par rapport au plot d'ancrage et dans laquelle le deuxième élément mécanique (24) est un deuxième plot d'ancrage solidaire du support.

15. Structure microélectronique résonante selon l'une des revendications 1 à 13, dans laquelle le premier élément mécanique est un plot d'ancrage solidaire d'un support et la masse mobile est mobile en translation le long d'une direction par rapport au support et dans laquelle le deuxième élément mécanique comporte une masse mobile en translation par rapport au support le long de ladite direction, les deux masses mobiles étant en opposition de phase.

**Patentansprüche**

1. Mikroelektronische Resonanzstruktur, enthaltend:

- zumindest eine bewegliche Masse (2), die über eine erste mechanische Verbindungsvorrichtung (6) bzw. eine zweite mechanische Verbindungsvorrichtung (14) mit zumindest einem ersten mechanischen Element und einem davon separaten zweiten mechanischen Element mechanisch verbunden ist, wobei die Masse dazu ausgelegt ist, durch einen äußeren Reiz in Schwingung versetzt zu werden,
- eine Strom- oder Spannungsvorspannungsquelle (15) für die zweite mechanische Verbindungsvorrichtung (14), wobei die zweite mechanische Verbindungsvorrichtung (14) zumindest ein erstes (18) und ein zweites (20) Verbindungselement und zumindest einen Wärmespeicher (22) enthält, der zwischen dem ersten und dem zweiten Verbindungselement eingesetzt ist, wobei zumindest eines aus erstem und zweitem Verbindungselement zumindest teilweise aus einem piezoresistiven Material besteht, wobei zumindest eines aus erstem und zweitem Verbindungselement thermoelastische Eigenschaften aufweist und wobei der Wärmespeicher (22) eine Wärmekapazität aufweist, die höher als die des ersten (18) und des zweiten (20) Verbindungselements ist, wobei die zweite Verbindungsvorrichtung (14) und die bewegliche Masse (2) so zueinander angeordnet sind, dass eine Verlagerung der beweglichen Masse (2) eine mechanische Spannung auf die zweite Verbindungsvorrichtung (14) aufbringt.

2. Mikroelektronische Resonanzstruktur nach Anspruch 1, wobei die Wärmekapazität des Wärmespeichers (22) höher ist als die des ersten (18) und des zweiten (20) Verbindungselements und vorzugsweise zumindest fünfmal so hoch ist wie die Wärmekapazität eines jeden Verbindungselements (18, 20).

3. Mikroelektronische Resonanzstruktur nach Anspruch 1 oder 2, wobei der Wärmespeicher (22) einen Flächenquerschnitt aufweist, der sich von den Querschnitten des ersten (18) und des zweiten Verbindungselements (20) unterscheidet.

4. Mikroelektronische Resonanzstruktur nach einem der Ansprüche 1 bis 3, wobei der Wärmespeicher (22) aus zumindest einem Material hergestellt ist, das eine Wärmekapazität hat, die sich von der der Materialien des ersten (18) und des zweiten (20) Verbindungselements unterscheidet, wobei das erste (18) und das zweite (20) Verbindungselement beispielsweise aus Silicium bestehen und der Wärmespeicher aus einer Aluminiumlegierung oder Beryllium besteht.

5. Mikroelektronische Resonanzstruktur nach einem der Ansprüche 1 bis 4, wobei das zumindest eine Verbindungselement mit thermoelastischen Eigenschaften aus zumindest einem Material mit einem Ausdehnungskoeffizienten von über $10^{-7} K^{-1}$ hergestellt ist.

6. Mikroelektronische Resonanzstruktur nach einem der Ansprüche 1 bis 5, wobei zumindest eines aus erstem und zweitem Verbindungselement aus zumindest einem piezoresistiven Material mit einem Ausdehnungskoeffizienten von unter $10^{-7} K^{-1}$ besteht und zumindest eines aus erstem und zweitem Verbindungselement aus zumindest einem nicht piezoresistiven Material besteht und einen Ausdehnungskoeffizienten von über $10^{-7} K^{-1}$ aufweist.

7. Mikroelektronische Resonanzstruktur nach einem der Ansprüche 1 bis 6, wobei das erste (18) und das zweite (20) Verbindungselement jeweils zumindest einen geradlinigen Steg enthalten.

8. Mikroelektronische Resonanzstruktur nach einem der Ansprüche 1 bis 7, wobei zumindest eines aus erstem und zweitem Verbindungselement zumindest einen Nanodraht enthält.

9. Mikroelektronische Resonanzstruktur nach einem der Ansprüche 1 bis 8, wobei die Steifheit des ersten (18) und des zweiten (20) Verbindungselements und der mechanischen Anschlüsse zwischen dem ersten Verbindungselement und der beweglichen Masse und zwischen dem zweiten Verbindungselement und dem zweiten mechanischen Element derart sind, dass eine Ausdehnung der zweiten Verbindungsvorrichtung im Wesentlichen eine Kraft auf die bewegliche Masse bewirkt.

10. Mikroelektronische Resonanzstruktur nach einem der Ansprüche 1 bis 9, wobei die Kapazität des Wärmespeichers (22) derart gewählt ist, dass die zweite Verbindungsvorrichtung (14) eine thermische Zeitkonstante $\tau_{th}$ aufweist, so dass $\tau_{th}\overline{\omega}_r \sim 1$ mit $\overline{\omega}_r$ als Resonanzfrequenz der mikroelektronischen Struktur.

11. Mikroelektronische Resonanzstruktur nach einem der Ansprüche 1 bis 10, wobei das erste und das zweite Verbindungselement sich in einer ersten Richtung erstrecken, wobei der Wärmespeicher in der ersten Richtung einen Mittelbereich enthält, der mit dem ersten und dem zweiten Verbindungselement verbunden ist und einen gegebenem Querschnitt aufweist, sowie Seitenbereiche in einer zweiten Richtung quer zur ersten Richtung, wobei die Seitenbereiche eine Abmessung in der ersten Richtung aufweisen, die größer als der gegebene Querschnitt des Mittelbereichs ist.

12. Mikroelektronische Resonanzstruktur nach einem der Ansprüche 1 bis 11, wobei die Vorspannungseinrichtungen (15) zwischen dem ersten mechanischen Element (12) und dem zweiten mechanischen Element (24) angeschlossen sind, wobei die erste (6) und die zweite (14) Verbindungsvorrichtung und die bewegliche Masse (2) vollständig oder teilweise elektrisch leitfähig sind.

13. Mikroelektronische Resonanzstruktur nach einem der Ansprüche 1 bis 12, wobei der Wärmespeicher einen Wärmewiderstand aufweist, der höchstens dreimal kleiner als die Wärmewiderstände der Verbindungselemente ist.

14. Mikroelektronische Resonanzstruktur nach einem der Ansprüche 1 bis 13, wobei das erste mechanische Element (12) ein fest mit einem Träger verbundenes Verankerungsstück ist und die bewegliche Masse (2) bezüglich des Verankerungsstücks drehbar angelenkt ist und wobei das zweite mechanische Element (24) ein fest mit dem Träger verbundenes zweites Verankerungsstück ist.

15. Mikroelektronische Resonanzstruktur nach einem der Ansprüche 1 bis 13, wobei das erste mechanische Element ein fest mit einem Träger verbundenes Verankerungsstück ist und die bewegliche Masse in einer Richtung bezüglich des Trägers verschiebbar ist und wobei das zweite mechanische Element eine bewegliche Masse enthält, die bezüglich des Trägers in der genannten Richtung verschiebbar ist, wobei die beiden beweglichen Massen gegenphasig sind.

**Claims**

1. A resonant microelectronic structure comprising:

   - at least one mobile mass (2)mechanically linked to at least one first mechanical element and a second mechanical element which are distinct, by a first mechanical linking device(6) and a second mechanical linking device (14) respectively, the mobile masse being configured to vibrate under the action of an external stimulus,
   - a source of polarisation (15) of current or voltage of the second mechanical linking device, (14) wherein the second mechanical linking device (14) comprises at least one first (18) and one second (20) linking element and at least one thermal reservoir (22) inserted between the first and second linking elements, at least one of the first and second linking elements being made at least in part of a piezoresistive material, where at least one of the first and second linking elements exhibit thermoelasticity properties, and the thermal reservoir (22) exhibiting a thermal capacity which is different from those of the first (18) and second (20) linking elements, wherein the second linking device (14) and the mobile mass (2) are arranged relative to each other such that a displacement of the mobile mass (2) applies a mechanical stress to the second linking device.

2. Resonant microelectronic structure according to claim 1 wherein the thermal capacity of the thermal reservoir (22) is greater than those of the first (18) and second (20) linking elements, advantageously equal to at least 5 times the thermal capacity of each linking element (18, 20).

3. Resonant microelectronic structure according to claim 1 or 2, wherein the thermal reservoir (22) has a transverse cross-section of surface area which is different to that of the transverse cross-sections of the first (18) and (20) second linking elements.

4. Resonant microelectronic structure according to any of the claims 1 a 3, wherein the thermal reservoir (22) is made from at least one material which exhibits a thermal capacity which differs from those of the materials of the first (18) and second (20)linking elements, for example the first (18) and second (20) linking elements are made of silicon and the thermal reservoir is made of an alloy of aluminium or beryllium.

5. Resonant microelectronic structure according to any of the claims 1 to 4, wherein at least one linking element exhibiting thermoelastic properties is made from at least one material which has an expansion coefficient greater than $10^{-7}K^{-1}$.

6. Resonant microelectronic structure according to any of the claims 1 to 5, wherein at least one of the first and the second linking element is made of at least one piezoresistive material which has a coefficient of expansion of less than $10^{-7}K^{-1}$ and at least one of the first and second linking elements is made of at least one non-piezoresistive material which has a coefficient of expansion greater than $10^{-7}K^{-1}$.

7. Resonant microelectronic structure according to any of the claims 1 to 6, wherein the first (18) and second (20) linking elements each comprise at least one straight beam.

8. Resonant microelectronic structure according to any of the claims 1 to 7, wherein at least one of the first and second linking elements comprise at least one nanowire.

9. Resonant microelectronic according to any of the claims 1 to 8, wherein the stiffness of the first (18) and second (20) linking elements and of mechanical connections between the first linking element and the mobile mass and between the second linking element and the second mechanical element are such that expansion of the second linking device primarily causes a force on the mobile mass.

10. Resonant microelectronic structure according to any of the claims 1 to 9, wherein the capacity of the thermal reservoir is chosen such that the second linking device exhibits a thermal time constant $\tau_{th}$ such that $\tau_{th}\omega_r{\sim}1$ where $\omega_r$ is a resonance frequency of the microelectronic structure.

11. Resonant microelectronic structure according to any of the claims 1 to 10, wherein the first and second linking elements extend along a first direction, wherein the thermal reservoir comprises a central zone linked to the first and second linking elements of given cross-section in the first direction and lateral zones in a second direction transverse to the first direction, said lateral zones having a dimension in the first direction which is greater than said given cross-section of the central zone.

12. Microelectronic structure according to any of the claims 1 to 11, wherein the polarisation means (15) are connected between the first mechanical element (12) and the second mechanical element (24), the first (6) and second (14) linking devices and the mobile mass (2) being all or partly electrically conductive.

13. Resonant microelectronic structure according to any of the claims 1 to 12, wherein the thermal reservoir exhibits a thermal resistance at most three times smaller than the thermal resistances of the linking elements.

14. Resonant microelectronic structure according to any of the claims 1 to 13, wherein the first mechanical element (12) is an anchorage stud, firmly attached to a support and the mobile mass (2) is pivoted so that it rotates relative to the anchorage stud and wherein the second mechanical element (24) is a second anchorage stud firmly attached to the support.

15. Resonant microelectronic structure according to any of the claims 1 to 13, wherein the first mechanical element is an anchorage stud firmly attached to a support and the mobile mass can move in translation along a direction relative to the support and wherein the second mechanical element comprises a mass which can move in translation relative to the support along said direction, with the two mobile masses being in phase opposition.

FIG.1

FIG.2

FIG.3

FIG.4

FIG.5A

FIG.5B

FIG.6

FIG.7

FIG. 8A

FIG. 8B

FIG. 8C

414

410

404

402

# FIG. 8D

414

412

410

404

402

# FIG. 8E

414

412

404

402

# FIG. 8F

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **LEHEE G ; SOUCHON F ; RIOU JC ; BOSSE-BOEUF A ; JOURDAN G.** Low power damping control of a resonant sensor using back action in silicon nanowires. *2016 IEEE 29th International Conference on Micro Electro Mechanical Systems (MEMS),* 2016, 99-102